# EUROPEAN PATENT APPLICATION

(11) **EP 0 974 844 A1**
(43) Date of publication of application: **26.01.2000**
(21) Application number: 99305150.7
(22) Date of filing: 30.06.1999
(51) Int. Cl.: G01R 1/067

(54) **Electrical probe with light source**

(30) Priority: 20.07.1998 US 119101
(71) Applicant: Hewlett-Packard Company, Palo Alto, California 94304 (US)
(72) Inventor: Whiteman, Donald A., Colorado Springs, Colorado 80917 (US)
(74) Representative: Powell, Stephen David

(57) **Abstract**

An electrical probe assembly (10) for connection to an electrical instrument, such as an oscilloscope (20),
includes a probe (12) having a probe body (30) and a sensing element (32) affixed to the probe body, a light source (40) affixed to the probe (12) for illuminating a region or circuit being probed with the sensing element (32), and conductors (46, 48) for connecting the light source (40) to a source of electrical energy. The light source (40) may comprise a white light-emitting diode and may be energized by a power supply located in the instrument.

## Description

This invention relates to electrical probes that are used with oscilloscopes and other electrical instruments and, more particularly, to an electrical probe having a light source for illuminating a circuit being probed.

Oscilloscopes, voltmeters and other electrical instruments utilize a probe for sensing waveforms, voltages and the like. The probe is typically a small, handheld assembly having an electrical sensing element. The probe is connected by a flexible cable and a connector to the oscilloscope or other instrument. In use, the sensing element is placed in contact with a node in an electrical circuit. A sensed parameter, such as a signal, a voltage or a waveform, is transmitted from the sensing element to the instrument for measurement and/or display.

It is frequently necessary to probe electrical equipment that is located in poorly illuminated areas or within electrical assemblies, such as card racks. where lighting is poor. Furthermore, the trend in electrical circuitry is toward small devices having fine lead pitches and toward small linewidths. Thus, it may be difficult to probe electrical circuitry in such poorly illuminated areas and to obtain the measurements needed. In addition, it is difficult to avoid short circuiting adjacent leads with the sensing element, which may damage the sensitive electrical circuits being probed.

Accordingly, there is a need for improved electrical probes in which one or more of the above disadvantages is overcome.

According to a first aspect of the invention, an electrical probe assembly is provided for connection to an electrical instrument. The probe assembly comprises a probe including a probe body and a sensing element affixed to the probe body, a light source affixed to the probe for illuminating a region being probed with the sensing element, and conductors for connecting the light source to a source of electrical energy. In a preferred embodiment, the probe is configured for operation with an oscilloscope.

The light source may comprise a light-emitting diode and, in a preferred embodiment, comprises a white light-emitting diode. In other embodiments, the light source may comprise a miniature incandescent lamp. The light source may comprise two or more light-emitting elements.

In one embodiment, the electrical source for energizing the light source is located in the instrument. In that case, the conductors pass through a cable that connects the probe to the electrical instrument. In another embodiment, the electrical source for energizing the light source comprises a battery that may be located in the probe.

The probe assembly may further comprise a switch for activating the light source. The switch may be mounted in the probe body for easy access by the user.

The probe assembly may further comprise an optical element, such as a lens, for shaping light emitted by the light source. An optical fiber may be used for transmitting light from the light source to the region being probed. A reflector may be utilized for redirecting at least a portion of the light emitted by the light source.

For a better understanding of the present invention, reference is made to the accompanying drawings, which are incorporated herein by reference and in which:
FIG. 1 is a schematic block diagram of a probe assembly incorporating a light source in accordance with the invention;
FIG. 2 illustrates a printed circuit board which may be used in the probe assembly of FIG. 1; and
Figs 3-5 illustrate examples of configurations of the light source in accordance with the invention.

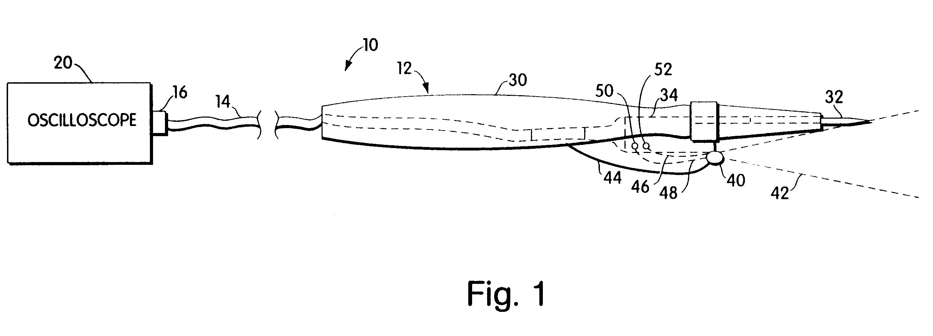

An example of a probe assembly incorporating the present invention is shown in FIG. 1. A probe assembly 10 includes a probe 12, a cable 14 and a connector 16. The probe assembly is connected via connector 16 to an oscilloscope 20 or other electrical instrument.

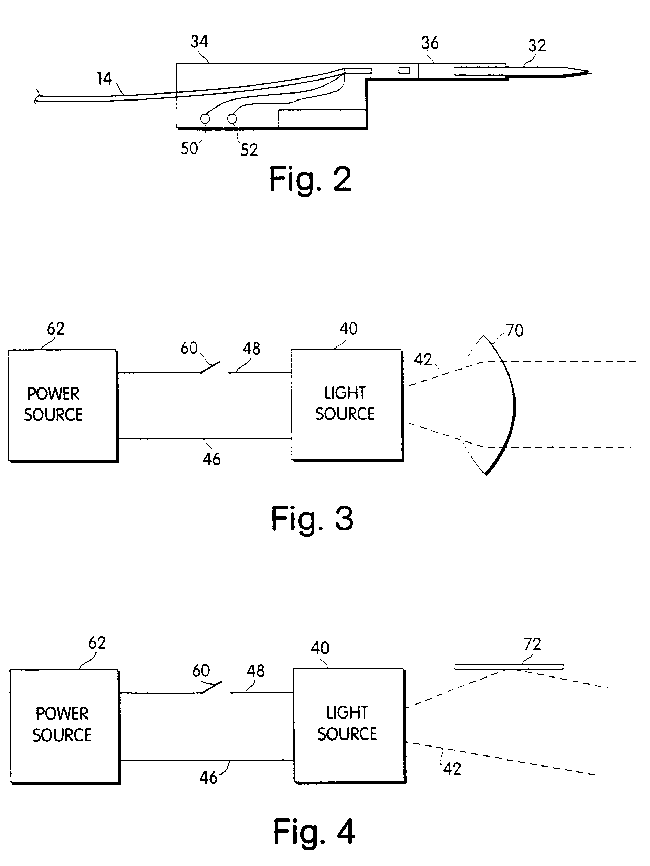

Probe 12 includes a probe body 30 and a sensing element 32 attached to probe body 30. Sensing element 32 may be a conductive probe tip attached to a printed circuit board 34 mounted within probe body 30. as shown in FIG. 2. Sensing element 32 is connected, either directly or indirectly through interface circuitry, to oscilloscope 20. Sensing element 32 may be mounted to an extension 36 of printed circuit board 34. Printed circuit board 34 may include circuitry as appropriate for a particular application. The details of such circuitry are outside the scope of the present invention.

Probe 12 is configured for manual operation. Sensing element 32 is placed in electrical contact with a node of interest in an electrical circuit. A sensed parameter is transmitted through cable 14 to oscilloscope 20 and is measured and/or displayed by oscilloscope 20. In some cases, the sensed parameter may be preprocessed by circuitry within probe 12.

In accordance with a feature of the invention, a light source 40 is affixed to probe 12. Light source 40 generates a light beam 42 for illuminating a region or circuit being probed with sensing element 32. In the example of FIG. 1, light source 40 is mounted to an enlarged portion 44 of probe body 30.

Conductors 46 and 48 connect light source 40 to a source of electrical energy, which may have any convenient location as described below. In the example of FIGS. 1 and 2, light source 40 is connected via conductors 46 and 48 to terminals 50 and 52, respectively, on printed circuit board 34. Terminals 50 and 52 are connected by conductors on printed circuit board 34 to cable 14. Conductors within cable 14 connect light source 40 to a power supply within oscilloscope 20.

Light source 40 may be any device that produces visible light of sufficient intensity for illuminating the region being probed with sensing element 32. Light source 40 is preferably a light-emitting diode (LED) which produces radiation in the visible wavelength range. A white LED is preferred. An example of a suitable device is type CMD1224WC manufactured by Chicago Miniature Lamp, Inc. Alternatively, miniature incandescent lamps may be utilized. Furthermore, more than one light-emitting device may be utilized for more uniform and/or more intense illumination. In general. the requirements of light source 40 are to generate sufficient illumination to facilitate use of probe assembly 12 in poorly illuminated areas and to avoid generation of excessive heat in probe 12, with minimum impact on the size and cost of the probe assembly 10.

Light source 40 may be mounted at any convenient location on probe 12. Preferably, light source 40 is mounted near sensing element 32 and is mounted so as to direct light beam 42 toward the region or circuit being probed by sensing element 32. In the example of FIG. 1, light beam 42 is directed approximately parallel to a longitudinal axis of probe 12.

The power source for energizing light source 40 is conveniently located within oscilloscope 20. One of the power supplies utilized in oscilloscope 20 can typically provide sufficient power for energizing light source 40 without modification. As noted above conductors extend from the power supply through cable 14 and conductors 46 and 48 to light source 40. In another configuration, a battery (not shown) can be mounted within probe 12 for energizing light source 40. Typical power supply requirements are 6 volts at 20 milliamps. In general, the power source can have any desired location.

The electrical probe having a light source in accordance with the invention has been described thus far in connection with an oscilloscope probe. It will be understood that electrical probes are used with a variety of other electrical instruments such as, for example, voltmeters. The probe assembly of the invention having a light source may be utilized with any electrical instrument. Furthermore, such probes have a wide variety of sizes, shapes and configurations. The present invention is generally applicable to such electrical probes.

A basic light source configuration includes light source 40 connected by conductors 46 and 48 to a power source. Schematic block diagrams of examples of light source configurations having additional optional features are shown in FIGS. 3-5.

Referring to FIG. 3, light source 40 is coupled through a switch 60 to power source 62, which as noted above may be a power supply or a battery. Switch 60 may be used to energize light source 40 when the probe assembly 10 is being utilized in a poorly illuminated area. Switch 60 may be a toggle switch or an on momentary switch and may, for example, be mounted on probe body 30.

The output of light source may be modified to produce the desired illumination of the region or circuit being probed. As shown in FIG. 3, light beam 42 generated by light source 40 may be modified by a lens 70. Lens 70 may be selected to spread, collimate or concentrate light beam 42. A ring lens may be utilized to generate a circular light pattern.

As shown in FIG. 4, all or a portion of light beam 42 may be redirected by a reflector 72. Reflector 72 may be utilized to direct light beam 42 toward the region or circuit being probed.

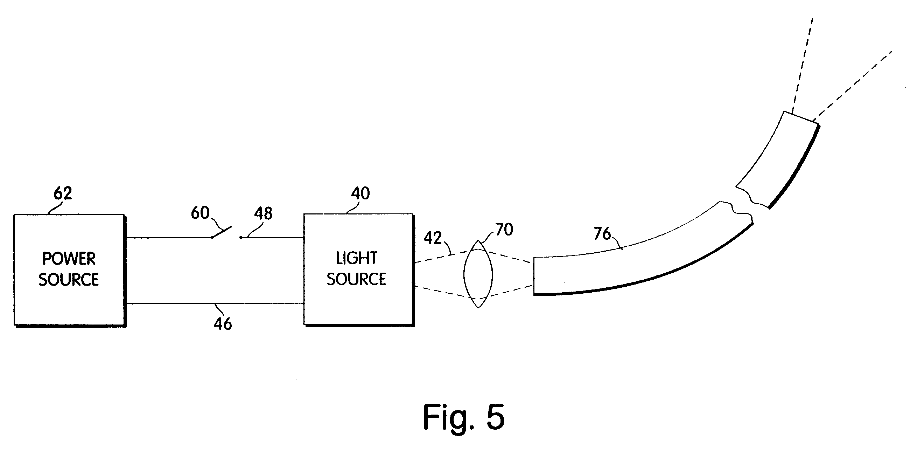

As shown in FIG. 5, light beam 42 generated by light source 40 may be transmitted through an optical fiber 76 to the region being probed. By using optical fiber 76, light source 40 can have any convenient location. A disadvantage of the configuration shown in FIG. 5 is that it is more complex and costly than the configuration of Figs. 1 and 2.

While there have been shown and described what are at present considered the preferred embodiments of the present invention, it will be obvious to those skilled in the art that various changes and modifications may be made therein without departing from the scope of the invention as defined by the appended claims.

## Claims

1. An electrical probe (10) assembly for connection to an electrical instrument comprising:
a probe (12) comprising a probe body (30) and a sensing element (32) affixed to said probe body;
a light source (40) affixed to said probe (12) for illuminating a region being probed with said sensing element (32); and
conductors (46, 48) for connecting said light source (40) to a source of electrical energy.

2. An electrical probe assembly as defined in claim 1 wherein said light source comprises a light-emitting diode.

3. An electrical probe assembly as defined in claim 2 wherein said light-emitting diode emits white light.

4. An electrical probe assembly as defined in claim 1 wherein said light source comprises a miniature incandescent lamp.

5. An electrical probe assembly as defined in claim 1 further comprising an optical element for shaping light emitted by said light source.

6. An electrical probe assembly as defined in claim 1 further comprising a switch for activating said light source.

7. An oscilloscope probe assembly (10) for connection to an oscilloscope, comprising:
an oscilloscope probe (12) comprising a probe body (30) and a sensing element (32) attached to said probe body;
a light-emitting diode (40) attached to said probe (12) for illuminating a region being probed with said sensing element (32); and
conductors (46, 48) for connecting said light-emitting diode (40) to a source of electrical energy.

8. An oscilloscope probe assembly as defined in claim 7 wherein said light-emitting diode emits white light.

9. An oscilloscope probe assembly as defined in claim 7 further comprising a switch coupled in series with said light-emitting diode.

10. A method for sensing an electrical parameter, comprising the steps of:
connecting a probe (12) comprising a probe body (30) and a sensing element (32) affixed to said probe body to an electrical instrument (20);
illuminating a region being probed with a light source (40) affixed to said probe (12); and
placing the sensing element (32) in contact with a node in an electrical circuit in the illuminated region.
